# DEMANDE DE BREVET EUROPEEN

(11) **EP 4 030 487 A1**
(43) Date de publication de la demande: **20.07.2022**
(21) Numéro de dépôt: 22151785.7
(22) Date de dépôt: 17.01.2022
(51) Int. Cl.: H01L 29/423, H01L 29/76, H01L 21/334, H01L 29/40, B82Y 10/00, B82Y 40/00

(54) **DISPOSITIF SEMICONDUCTEUR ET PROCÉDÉ DE FABRICATION ASSOCIÉ**

(30) Priorité: 18.01.2021 FR 2100440
(71) Demandeur: Commissariat à l'Energie Atomique et aux Energies Alternatives, 75015 Paris (FR)
(72) Inventeur: LE ROYER, Cyrille, 38054 GRENOBLE CEDEX 09 (FR); HUTIN, Louis, 38054 GRENOBLE CEDEX 09 (FR); NEMOUCHI, Fabrice, 38054 GRENOBLE CEDEX 09 (FR); POSSEME, Nicolas, 38054 GRENOBLE CEDEX 09 (FR)
(74) Mandataire: Cabinet Camus Lebkiri

(57) **Abrégé**

Un aspect de l'invention concerne un dispositif (DI) semiconducteur comprenant : un substrat (ST) ; une pluralité d'empilements de grille (EGx) situés horizontalement à la suite les uns des autres sur le substrat (ST), chaque empilement de grille (EGx) comprenant une couche (OG) d'un matériau diélectrique en contact avec le substrat (ST) et une couche (GR) d'un matériau conducteur sur la couche (OG) d'un matériau diélectrique ; une source et un drain (S/D) situés sur le substrat de part et d'autre de la pluralité d'empilement de grille (EGx) ; une pluralité de premiers espaceurs (SExx) dans un premier matériau diélectrique, dit espaceurs secondaires (SExx), ayant une première largeur, dite largeur des espaceurs secondaires, la source et le drain étant séparé de l'empilement de grille (EGx) le plus proche par un unique espaceur secondaire (SExx) ; au moins un espaceur principale (ESx) dans un deuxième matériau diélectrique, un espaceur principal (ESx) étant situé entre chaque empilement de grille (EGx), la largeur du ou des espaceurs principaux (ESx) étant supérieure à la largeur des espaceurs secondaires (SExx).

## Description

### DOMAINE TECHNIQUE DE L'INVENTION

Le domaine technique de l'invention est celui de l'électronique, notamment l'électronique quantique.

La présente invention concerne un dispositif semi-conducteur susceptible d'être utilisé comme qbits (pour bit quantique ou quantum bit en anglais) de spin dans un matériau semiconducteur tel que le silicium.

### ARRIERE-PLAN TECHNOLOGIQUE DE L'INVENTION

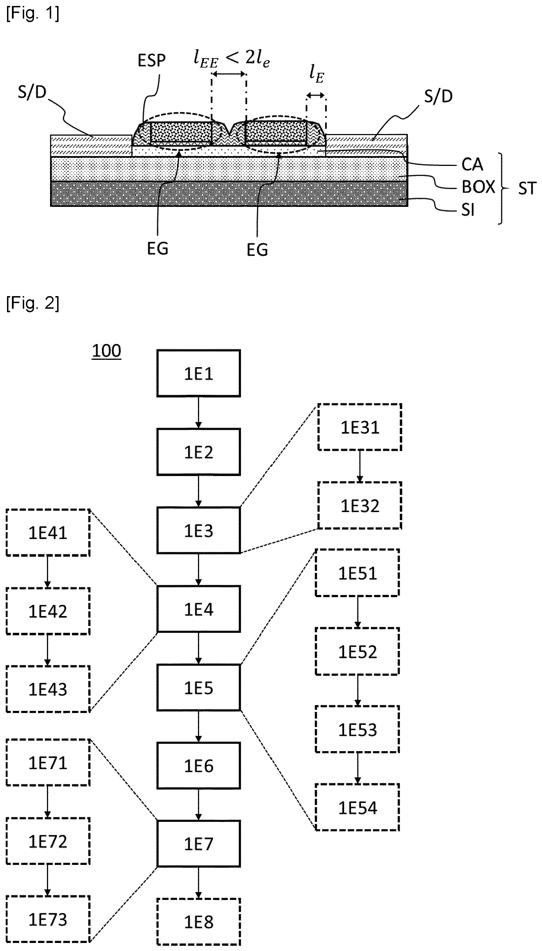

Afin de produire des qbits de spin, il est connu d'utiliser un dispositif comprenant deux empilements de grille EG ainsi qu'une source et un drain S/D tel que représenté à la figure 1. Chaque empilement de grille EG est entouré d'un espaceur ESP d'une largeur donnée *l_{E}* de sorte qu'un empilement de grille EG est séparé de la source ou du drain S/D par une largeur fixé par la largeur *l_{E}* de cet espaceur ESP. De plus, les deux empilements de grille EG sont séparés d'une distance *l_{EE}* qui ne peut être qu'inférieure à deux fois la largeur de l'espaceur de sorte que *l_{EE}* < 2*l_{E}*. Une telle structure présente cependant certains inconvénients.

Tout d'abord, l'accès côté source et côté drain S/D est limité par la largeur *l_{E}* de l'espaceur ESP. Or, cette largeur fixe également la distance maximale séparant deux empilements de grilles EG. Il y a donc peu de possibilités d'optimisation entre un bon accès côté source et côté drain et une distance suffisante entre les deux empilements de grille EG. Cela limite également la densité de dispositifs qu'il est possible de réaliser sur une plaque.

Ensuite, afin de manipuler les états de spin dans la structure, il est nécessaire d'envoyer un signal radio fréquence (pour les phases d'écriture, entre 1 et 10GHz - pour les phases de lecture, environ 100 MHz). Or, des capacités parasites entre les grilles ou entre une grille et le canal CA sous la grille voisine sont susceptibles de venir perturber les opérations de lecture ou d'écriture. Il est alors nécessaire de compenser ces perturbations, ce qui accroit la complexité des signaux de manipulation ou de lecture. Bien entendu, de telles capacités parasites pourraient être réduites en augmentant la distance *l_{EE}* entre les empilements de grille EG, mais cela entrainerait également une augmentation de la distance *l_{E}* séparant la source ou le drain S/D du plus proche empilement de grille EG, ce qui nuirait au bon accès côté source ou côté drain.

Il existe donc un besoin de fournir un dispositif dont la dimension des séparateurs entre les empilements de grille n'est pas dictée par la dimension des séparateurs entre la source ou le drain et l'empilement de grille qui leur est le plus proche, permettant notamment d'augmenter la densité de dispositifs. Il existe également le besoin d'élaborer un procédé permettant d'obtenir un tel dispositif.

### RESUME DE L'INVENTION

L'invention offre une solution aux problèmes évoqués précédemment, en proposant un procédé de fabrication permettant de découpler le choix des dimensions des espaceurs séparant les empilements de grille des dimensions des espaceurs séparant la source ou le drain de l'empilement de grille qui lui est le plus proche.

Un aspect de l'invention concerne un procédé de fabrication d'un dispositif semiconducteur à partir d'un substrat, le procédé comprenant :
- une étape de dépôt, sur le substrat, d'une première couche d'un matériau diélectrique selon une première épaisseur prédéterminée ;
- une étape de gravure d'une partie de la première couche d'un matériau diélectrique sur la totalité de la première épaisseur définissant, dans la première couche d'un matériau diélectrique, une pluralité de cavités séparées par des espaceurs, dit espaceurs principaux, chaque cavité ayant une première paroi latérale et une deuxième paroi latérale, les deux parois latérales de cavités les plus éloignées l'une de l'autre étant désignées par parois extrêmes ;
- une étape de dépôt d'une deuxième couche d'un matériau diélectrique sur les parois latérales des cavités définies lors de l'étape de gravure précédente de sorte à définir une pluralité d'espaceurs secondaires sur les espaceurs principaux et les parois extrêmes ;
- une étape de création, dans chaque cavité, d'un empilement de grille comprenant une troisième couche d'un matériau diélectrique en contact avec le substrat et une quatrième couche d'un matériau conducteur sur la troisième couche d'un matériau diélectrique, l'empilement de grille ainsi créé ayant une hauteur supérieure ou égale à la première épaisseur ;
- une étape de création d'un masque dur, ledit masque dur recouvrant entièrement les empilements de grille ainsi que les espaceurs principaux et secondaires ;
- une étape de gravure de la partie de la première couche d'un matériau diélectrique non protégée par le masque dur, la gravure étant effectuée sur la totalité de la première épaisseur ;
- une étape de création d'un module source-drain dans les zones laissées libres par la partie de la première couche gravée lors de l'étape de gravure précédente.

Grâce au procédé selon l'invention, il est possible de décorréler la dimension de l'espaceur situé entre la source ou le drain et l'empilement de grille le plus proche de la dimension de chaque espaceur séparant deux empilements de grille successifs. Il est en outre possible de choisir des tailles de séparateur différentes entre les empilements de grille de sorte qu'un premier empilement de grille du dispositif pourra être séparé d'un deuxième empilement de grille par un premier espaceur ayant une première largeur tandis que le deuxième empilement de grille sera séparé d'un troisième empilement de grille par un deuxième espaceur ayant une largeur qui peut être différente de la première largeur.

Outre les caractéristiques qui viennent d'être évoquées dans le paragraphe précédent, le procédé selon un premier aspect de l'invention peut présenter une ou plusieurs caractéristiques complémentaires parmi les suivantes, considérées individuellement ou selon toutes les combinaisons techniquement possibles.

Dans un mode de réalisation, le procédé comprend en outre une étape de retrait du masque dur.

Dans un mode de réalisation, le masque dur forme avec chaque paroi extrême un rebord.

Dans un mode de réalisation, l'étape de dépôt d'une deuxième couche d'un matériau diélectrique sur les parois latérales des cavités comprend :
- une sous-étape de dépôt d'une couche d'un matériau diélectrique ; et
- une sous-étape de gravure de la deuxième couche d'un matériau diélectrique de sorte à ne laisser la deuxième couche d'un matériau diélectrique que sur les parois latérales des cavités.

Dans un mode de réalisation, l'étape de création, dans chaque cavité, d'un empilement de grille comprend :
- une sous-étape de dépôt ou de croissance de la troisième couche d'un matériau diélectrique sur le substrat ;
- une sous-étape de dépôt de la quatrième couche d'un matériau conducteur sur la troisième couche d'un matériau diélectrique ; et
- une sous-étape de polissage mécano-chimique de sorte que la hauteur de l'empilement de grille soit égale à la première épaisseur.

Dans un mode de réalisation, l'étape de création d'un masque dur comprend :
- une sous-étape de dépôt d'une couche destinée à former le masque dur ;
- une sous-étape de lithographie de sorte à définir la zone formant le masque dur ;
- une sous-étape de gravure de la couche destinée à former le masque dur en fonction de la zone définie lors de la sous-étape de lithographie ; et
- une sous-étape de délaquage (ou stripping en anglais) de sorte à définir le masque dur.

Dans un mode de réalisation, l'étape de création d'un module source-drain comprend :
- une sous-étape de croissance sélective d'une couche de silicium dans la zone laissée libre par la partie de la première couche gravée lors de l'étape précédente ;
- une sous-étape de dopage de la couche de silicium ainsi déposée ;
- une sous-étape d'activation des dopants.

Dans un mode de réalisation, le substrat est un substrat de type SOI (de l'anglais Silicon On Insulator).

Un deuxième aspect de l'invention concerne un dispositif semiconducteur susceptible d'être obtenu à l'aide d'un procédé selon un premier aspect de l'invention. Plus particulièrement, le dispositif selon un deuxième aspect de l'invention comprend :
- un substrat ;
- une pluralité d'empilements de grille situés horizontalement à la suite les uns des autres sur le substrat, chaque empilement de grille comprenant une couche d'un matériau diélectrique en contact avec le substrat et une couche d'un matériau conducteur sur la couche d'un matériau diélectrique ;
- une source et un drain situés sur le substrat de part et d'autre de la pluralité d'empilement de grille ;
- une pluralité de premiers espaceurs dans un premier matériau diélectrique, dit espaceurs secondaires, ayant une première largeur identique pour tous les espaceurs secondaires, dite largeur des espaceurs secondaires, la source et le drain étant séparés de l'empilement de grille le plus proche par un espaceur secondaire ;
- au moins un espaceur principal dans un deuxième matériau diélectrique, deux espaceurs secondaires et un espaceur principal intercalé entre les deux espaceurs secondaires étant situés entre chaque empilement de grille.

Outre les caractéristiques qui viennent d'être évoquées dans le paragraphe précédent, le dispositif selon un deuxième aspect de l'invention peut présenter une ou plusieurs caractéristiques complémentaires parmi les suivantes, considérées individuellement ou selon toutes les combinaisons techniquement possibles.

Dans un mode de réalisation, la largeur du ou des espaceurs principaux est supérieure à la largeur des espaceurs secondaires.

Dans un mode de réalisation, le dispositif comprend au moins deux empilements de grille.

Dans un mode de réalisation, la source et le drain sont surélevés par rapport au substrat.

Dans un mode de réalisation, la source et le drain sont séparés de l'empilement de grille le plus proche par un unique espaceur secondaire.

L'invention et ses différentes applications seront mieux comprises à la lecture de la description qui suit et à l'examen des figures qui l'accompagnent.

### BREVE DESCRIPTION DES FIGURES

Les figures sont présentées à titre indicatif et nullement limitatif de l'invention.
La [Fig. 1] montre un dispositif selon l'état de l'art antérieur.
La [Fig. 2] montre un ordinogramme d'un procédé de fabrication selon un premier aspect de l'invention, les étapes en pointillés étant relatives à des modes de réalisation particulier.
La [Fig. 3] montre un substrat de type SOI susceptible d'être utilisé dans un procédé selon un premier aspect de l'invention.
La [Fig. 4] montre une étape de dépôt d'une première couche d'un matériau diélectrique selon l'invention.
La [Fig. 5] montre une étape de gravure de la première couche d'un matériau diélectrique selon l'invention.
La [Fig. 6] montre une étape de dépôt d'une deuxième couche d'un matériau diélectrique sur les parois latérales des cavités selon l'invention.
La [Fig. 7] montre une étape de création, dans chaque cavité, d'un empilement de grille selon l'invention.
La [Fig. 8] montre une étape de création d'un masque dur selon l'invention.
La [Fig. 9] montre une étape de gravure de la partie de première couche d'un matériau diélectrique non protégée par le masque dur selon l'invention.
La [Fig. 10] montre une étape de création d'un module source-drain selon l'invention.
La [Fig. 11] montre un dispositif obtenu à l'aide d'un procédé selon l'invention.

### DESCRIPTION DETAILLEE

Sauf précision contraire, un même élément apparaissant sur des figures différentes présente une référence unique. Dans la suite, lorsque plusieurs références ne se différencient que par leurs indices numériques, par exemple C1 et C2, il pourra être fait référence à l'ensemble de ces références en remplaçant leurs indices numériques par la lettre x, par exemple Cx. Par ailleurs, les différents éléments seront décrits tels qu'ils apparaissent dans un plan de coupe perpendiculaire à la surface du substrat sur lequel est mis en œuvre le procédé (ou réalisé le dispositif), l'axe d'alignement des empilements de grilles étant compris dans ce plan de coupe.

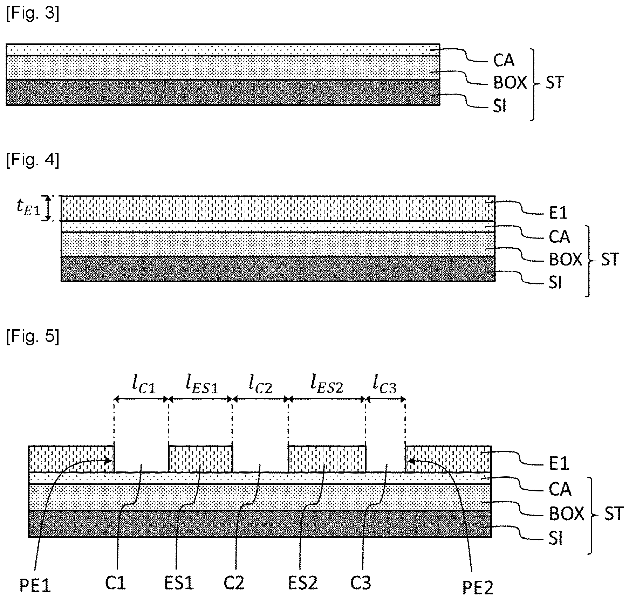

Un premier aspect de l'invention illustré à la figure 2 concerne un procédé 100 de fabrication d'un dispositif semiconducteur à partir d'un substrat ST. Dans un mode de réalisation, le substrat est un substrat de type SOI (de l'anglais Silicon On Insulator) tel qu'illustré à la figure 3 comprenant une couche de silicium SI, une couche d'oxyde BOX (appelé oxyde enterré ou *buried oxide* en anglais) sur la couche de silicium SI et une seconde couche de silicium CA, cette seconde couche CA de silicium étant susceptible de former un canal de transistor.

Le procédé 100 selon l'invention comprend une étape 1E1 de dépôt, sur le substrat ST, d'une première couche E1 d'un matériau diélectrique selon une première épaisseur prédéterminée *t*_{*E*1}*.* Cette étape 1E1 est illustrée à la figure 4. De préférence, le matériau diélectrique de la première couche E1 est un matériau ayant une faible constante diélectrique, par exemple une constante diélectrique inférieure ou égale à 4*ε*₀. De préférence, le matériau de la première couche E1 d'un matériau diélectrique est l'oxyde de silicium (SiO₂). De préférence, l'épaisseur prédéterminée *t*_{*E*1} est choisie de sorte que 40 nm ≤ *t*_{*E*1} ≤ 100 nm. Plus généralement, l'épaisseur prédéterminée est choisie en fonction de la hauteur de grille désirée, cette hauteur de grille étant, comme cela sera décrit dans la suite, fonction de cette épaisseur prédéterminée *t*_{*E*1}*.*

Le procédé 100 selon l'invention comprend ensuite une étape 1E2 de gravure d'une partie de la première couche E1 d'un matériau diélectrique sur la totalité de la première épaisseur *t*_{*E*1} de sorte à définir une pluralité de cavités Cx (c'est-à-dire au moins deux cavités Cx) séparées par des espaceurs ESx, dit espaceurs principaux. Ainsi chaque cavité Cx est définie par une première paroi latérale et une deuxième paroi latérale de deux espaceurs ESx principaux. Lorsqu'une cavité est située entre un premier espaceur principal ESx et un deuxième espaceur principal ESx, alors la première paroi latérale est une paroi latérale du premier espaceur principal ESx et la deuxième paroi latérale est une paroi latérale du deuxième espaceur principal ESx. Par ailleurs, il est possible de distinguer deux parois de cavité Cx particulières qui ne peuvent être associée à aucun espaceur principal ESx car situées aux deux extrêmes de la succession de cavités Cx et qui correspondent aux parois latérales de la première couche E1 d'un matériau diélectrique. Dans la suite, comme illustré à la figure 5, ces deux parois de cavités Cx les plus éloignées l'une de l'autre sont désignées parois latérale extrêmes PE1, PE2.

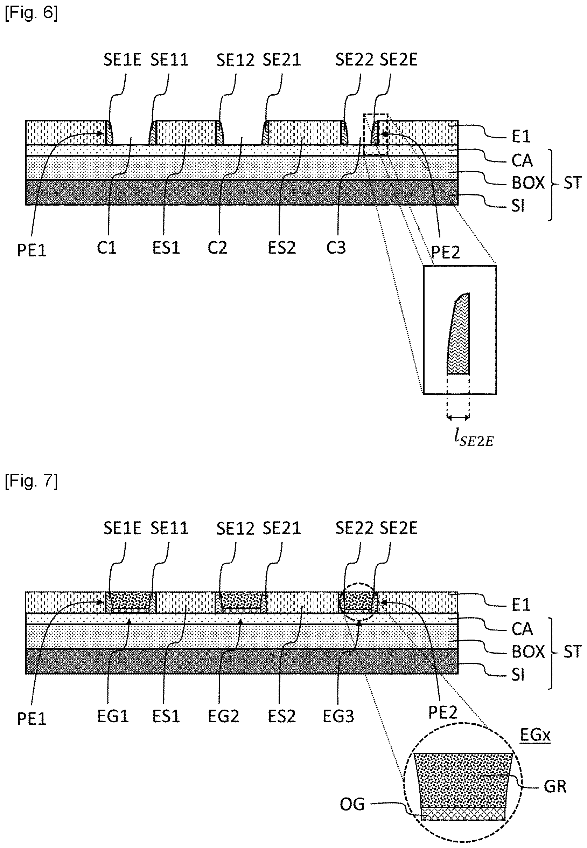

Plusieurs paramètres peuvent être associés à cette étape et notamment la largeur des espaceurs principaux ESx (autrement dit, la distance séparant chaque cavité Cx), notée *l_{ESi}* sur la figure 5 avec *i* l'indice de l'espaceur ESx considéré, et la largeur de chaque cavité, notée *l_{Cj}* sur la figure 5 avec *j* l'indice de la cavité Cx considérée. Chaque cavité Cx ainsi formée étant destinée à recevoir un empilement de grille EGx (cf. figure 6 décrite plus loin), la largeur *l_{Cj}* de chaque cavité définit la largeur de l'empilement de grille EGx et la distance *l_{ESi}* séparant chaque cavité définie la largeur des espaceurs principaux ESx séparant chaque empilement de grille EGx. Dans un mode de réalisation, cette étape 1E2 peut être mise en œuvre à l'aide d'une lithographie DUV, par exemple une méthode DUV par immersion, ou bien encore à l'aide d'une lithographie électronique, suivie d'une gravure (*etching* en anglais) et d'une étape de retrait de la résine, par exemple par délaquage (ou stripping en anglais). D'autres solutions connues de l'homme du métier sont bien entendu envisageables.

Cette étape 1E2 est illustrée sur la figure 5 dans le cas de trois cavités Cx. La première cavité C1 a une largeur *l*_{*C*1}, la deuxième cavité C2 a une largeur *l*_{*C*2} et la troisième cavité a une largeur *l*_{*C*3}. En outre, dans l'illustration de la figure 5, les largeurs sont telles que *l*_{*C*1} ≠ *l_{C2}* ≠ *l_{C3}.* Cependant, le procédé 100 selon l'invention permet une grande souplesse dans le choix de ces dimensions et d'autres relations entre les largeurs des cavités sont envisageables, par exemple les largeurs des trois cavités Cx pourraient être identiques. De plus, dans l'exemple de la figure 5, la première cavité C1 et la deuxième cavité C2 sont séparées par un premier espaceur principal ES1 de largeur *l*_{*ES*1} tandis que la deuxième cavité C2 et la troisième cavité C3 sont séparées par un deuxième espaceur principal ES2 de largeur *l*_{*ES*2}. Dans l'illustration de la figure 5, *l*_{*ES*1} ≠ *l*_{*ES*2}*,* mais, comme cela a déjà été mentionné, le procédé 100 selon l'invention permet une grande souplesse dans le choix de ces dimensions et d'autre relations entre les largeurs des espaceurs principaux ESx sont envisageables, par exemple les largeurs des deux espaceurs principaux *l*_{ESx} pourraient être identiques.

Le procédé 100 selon l'invention comprend ensuite une étape 1E3 de dépôt d'une deuxième couche SExx d'un matériau diélectrique sur les parois latérales des espaceurs principaux ESx définie lors de l'étape 1E2 de gravure de la première couche E1 d'un matériau diélectrique ainsi que sur les parois extrêmes PE1, PE2 (autrement dit, sur toutes les parois latérales définissant chaque cavité Cx) de sorte à définir une pluralité d'espaceur secondaire SExx. De préférence, le matériau diélectrique de la deuxième couche SExx est un matériau à faible constante diélectrique (par exemple, inférieure ou égale à 4*ε*₀), comme de l'oxyde de carbure de silicium SiCO ou bien encore du SiBCN. De préférence, la largeur *l_{SExx}* de la couche de matériau diélectrique à la base de chaque espaceur ESx (c'est-à-dire au niveau du fond de chaque cavité Cx) est comprise entre 3 nm et 15 nm, avantageusement égale à 10nm.

Cette étape 1E3 est illustrée à la figure 6 dans le cas de trois cavités Cx. A l'issue de cette étape 1E3, un premier espaceur secondaire extrême SE1E est formé au niveau de la première parois extrême PE1 et une deuxième espaceur secondaire extrême SE2E est formé au niveau de la deuxième paroi extrême PE2. De plus, un espaceur secondaire SExx est formée sur chaque paroi de chaque espaceur ESx. Ainsi, les parois du premier espaceur principal ES1 sont recouvertes d'une couche d'un matériau diélectrique formant un premier espaceur secondaire SE11 et un deuxième espaceur secondaire SE12. Il en est de même pour le deuxième espaceur principal ES2.

Dans un mode de réalisation, l'étape 1E3 de dépôt d'une deuxième couche SExx d'un matériau diélectrique sur les parois latérales des espaceurs principaux et les parois extrêmes PE1, PE2 (autrement dit sur les parois latérales des cavités Cx) comprend une première sous-étape 1E31 de dépôt d'une deuxième couche d'un matériau diélectrique. Cette deuxième couche va donc recouvrir les parois latérales des espaceurs principaux ESx et les parois latérales extrême PE1, PE2 ainsi que le fond de chaque cavité Cx définies lors de l'étape 1E2 de gravure de la première couche E1 d'un matériau diélectrique. Afin de retirer la couche ainsi déposée au fond de chaque cavité Cx, l'étape 1E3 de dépôt d'une deuxième couche SExx d'un matériau diélectrique sur les parois latérales des espaceurs principaux ESx et les parois extrêmes PE1, PE2 comprend également une sous-étape 1E32 de gravure de la deuxième couche d'un matériau diélectrique, la gravure étant réalisée de sorte à ne laisser la deuxième couche de matériau diélectrique que sur les parois des espaceurs principaux ESx et les parois extrême PE1, PE2 (ou du manière équivalente sur les parois latérales des cavités Cx).

Dans un mode de réalisation, cette sous-étape 1E32 de gravure est une sous-étape de gravure anisotrope, par exemple une gravure plasma (gravure par ions réactif ou *reactive ion etching* en anglais). De manière générale, l'utilisation d'une sous-étape 1E32 de gravure produit une couche SExx telle qu'illustrée dans l'encadré de la figure 6, c'est-à-dire une couche dont l'épaisseur croit à mesure que l'on se rapproche de la base de l'espaceur SExx considéré (autrement dit du fond de la cavité Cx considérée). D'autres formes que celle présentée dans la figure 6 sont cependant envisageables.

Le procédé 100 selon l'invention comprend ensuite une étape 1E4 de création, dans chaque cavité Cx, d'un empilement de grille EGx comprenant une troisième couche OG un matériau diélectrique en contact avec le substrat ST et une quatrième couche GR d'un matériau conducteur sur la troisième couche OG d'un matériau diélectrique, l'empilement de grille EGx ainsi créé ayant une hauteur supérieure ou égale à la première épaisseur. Dans un mode de réalisation, la quatrième couche GR d'un matériau conducteur est une couche de polysilicium ou de métal comme le TiN. Dans un mode de réalisation, la troisième couche OG d'un matériau diélectrique est une couche de SiO₂, par exemple obtenue par une oxydation plasma ou, de préférence, par une oxydation thermique, cette dernière technique permettant d'obtenir un oxyde de meilleure qualité. Dans un mode de réalisation, l'épaisseur de la troisième couche OG d'un matériau diélectrique est comprise entre 2 nm et 10 nm, de préférence égale à 6 nm.

Cette étape 1E4 est illustrée à la figure 7 dans le cas de trois empilements de grille EGx. En partant de la droite, le premier empilement de grille EG1 est séparé du deuxième empilement de grille EG2 par la succession de trois espaceurs : le premier espaceur secondaire SE11 du premier espaceur principale ES1, le premier espaceur principal ES1 et le deuxième espaceur secondaire SE12 du premier espaceur principal ES1. Une même succession d'espaceurs sépare le deuxième empilement de grille EG2 du troisième empilement de grille EG3.

Dans un mode de réalisation, l'étape 1E4 de création, dans chaque cavité Cx, d'un empilement de grille EGx comprend une sous-étape 1E41 de dépôt ou de croissance d'une troisième couche OG d'un matériau diélectrique sur le substrat ST. De préférence, cette sous-étape 1E41 est réalisée par une oxydation thermique ou plasma, du silicium situé au fond de chaque cavité Cx. L'étape 1E4 de création d'un empilement de grille EGx comprend ensuite une sous-étape 1E42 de dépôt d'une quatrième couche GR d'un matériau conducteur sur la troisième couche OG d'un matériau diélectrique, par exemple du polysilicium et/ou un métal comme le TiN, l'épaisseur totale déposée lors de cette sous-étape 1E42 étant supérieure à la hauteur *t*_{*E*1} des cavités Cx, de préférence largement supérieure (c'est-à-dire de plus de 20%) à la hauteur *t*_{*E*1} des cavités Cx. L'étape 1E4 de création d'un empilement de grille EGx comprend ensuite une sous-étape 1E43 de polissage mécano-chimique (ou CMP pour *Chemical Mechanical Polishing* en anglais) de sorte que l'empilement de grille EGx ainsi obtenu ait une hauteur égale à la première épaisseur. En particulier, la sous-étape 1E43 de polissage chimio-mécanique permet de contrôler de manière précise la hauteur finale des empilements de grille EGx, par exemple pour réduire les capacités parasites précédemment évoquées.

De plus, le procédé 100 selon l'invention comprend une étape 1E5 de création d'un masque dur MA, ledit masque dur MA recouvrant entièrement les empilements de grille EG ainsi que les espaceurs principaux ESx et secondaires SExx. Dans un mode de réalisation, le matériau du masque dur MA est le SiN. Dans un mode de réalisation, l'épaisseur du masque dur MA est comprise entre 40 nm et 100 nm.

Dans un mode de réalisation, le masque dur MA forme avec chaque parois extrêmes PEx un rebord RBx. Il est possible de définir une largeur pour chaque rebord RBx comme la distance séparant une paroi extrême PEx de la surface verticale du masque dur MA la plus proche de la paroi extrême PEx considérée. De préférence, la largeur de chaque rebord RBx est inférieure à 30 nm, voire 15 nm.

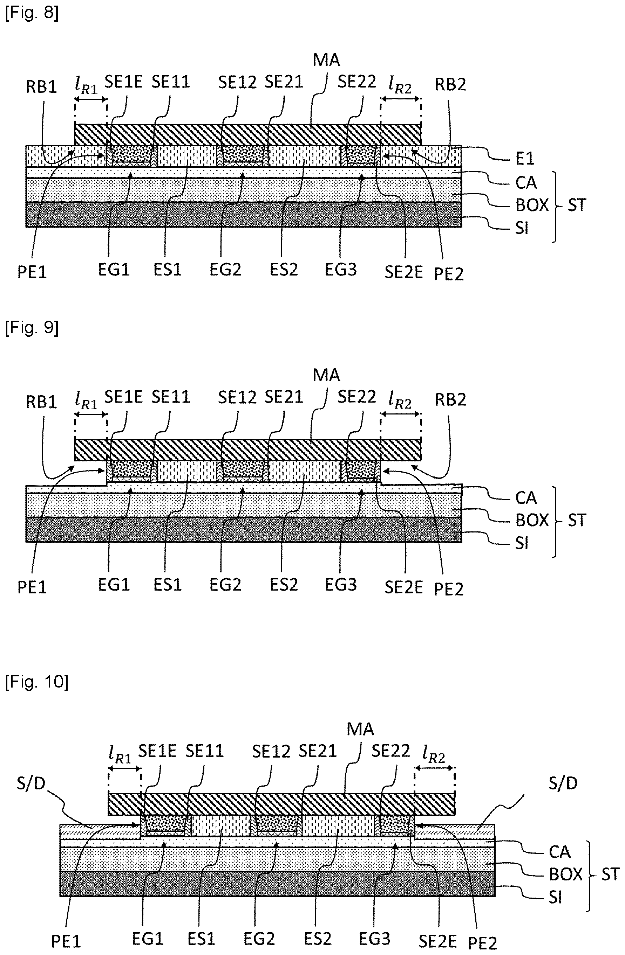

Cette étape 1E5 est illustrée à la figure 8. Sur cette figure, la première paroi extrême PE1 forme avec le masque dur MA un premier rebord RB1 de largeur *l*_{*R*1}. De même, la deuxième paroi extrême PE2 forme avec le masque dur MA un deuxième rebord RB2 de largeur *l*_{*R*2}. Le masque dur MA ainsi déposé vient protéger les empilements de grille EGx ainsi que les espaceurs principaux ESx et secondaire SExx, mais laisse les zones extrêmes (c'est-à-dire les zones non situées entre les deux parois extrêmes PEx) exposées.

Dans un mode de réalisation, l'étape 1E5 de création d'un masque dur MA comprend une sous-étape 1E51 de dépôt d'une couche destinée à former le masque dur MA. Cette étape 1E5 comprend ensuite une sous-étape 1E52 de lithographie de sorte à définir la zone formant le masque, une sous-étape 1E53 de gravure en fonction de la zone définie lors de la sous-étape de lithographie précédente et une sous-étape 1E54 de délaquage de sorte à définir le masque dur MA.

Le procédé 100 selon l'invention comprend ensuite une étape 1E6 de gravure de la partie de la première couche E1 d'un matériau diélectrique non protégée par le masque dur MA sur la totalité de la première épaisseur *t*_{*E*1}*.* Il est utile de noter que, lorsqu'un rebord RBX est formé entre le masque dur MA et les parois extrêmes PE1, PE2, l'étape 1E6 de gravure est une étape 1E6 de gravure isotrope et la partie située sous chaque rebord RBx n'est pas une zone protégée par le masque dur MA. Aussi, la gravure se produit également sous chaque rebord RBx.

De préférence, cette étape 1E6 de gravure est réalisée à l'aide d'une gravure humide fortement sélective de sorte à graver préférentiellement le matériau de la première couche E1 d'un matériau diélectrique. On entend par fortement sélective une gravure pour laquelle la vitesse de gravure pour le matériau de la première couche E1 d'un matériau diélectrique est au moins dix fois supérieure aux vitesses de gravures des autres matériaux en présence. Dans un mode de réalisation, le masque dur est en nitrure de silicium (SiN), la première couche E1 d'un matériau diélectrique est déposée sur du silicium et l'acide fluorhydrique (par ex. HF à 1% en volume) est utilisé pour effectuer la gravure de la première couche E1 d'un matériau diélectrique.

Cette étape est illustrée à la figue 9. Sur cette figure, la partie de première couche E1 d'un matériau diélectrique non protégée par le masque dur MA a été gravée sur la totalité de la première épaisseur *t*_{*E*1} exposant ainsi la surface du substrat ST. La gravure étant sélective, le premier espaceur secondaire extrême SE1E et le deuxième espaceur secondaire extrêmes SE2E n'ont pas été gravés (au moins de manière significative).

Le procédé comprend enfin une étape 1E7 de création d'un module source-drain S/D dans les zones laissées libres par la partie de la première couche E1 d'un matériau diélectrique gravée lors de l'étape 1E6 précédente.

Cette étape 1E7 est illustrée à la figure 10. Sur cette figure, la source et le drain S/D nouvellement créés sont en contact avec la surface du substrat ST, ici en contact avec la seconde couche CA de silicium du substrat SOI, cette dernière étant susceptible de former un canal de transistor. De plus, chaque source/drain est séparé de l'empilement de grille attenant EG1, EG3 par un espaceur secondaire extrême SE1E, SE2E.

Dans un mode de réalisation, l'étape 1E7 de création du module source-drain S/D comprend une sous-étape 1E71 de croissance sélective, par exemple par épitaxie, d'une couche de silicium dans la zone laissée libre par la partie de la première couche E1 gravée lors de l'étape 1E6 précédente. Le dépôt peut se faire avec la formation de facette et/ou avec dopage in-situ. On entend par croissance sélective que la vitesse de croissance du matériau sur la surface du substrat (ici la seconde couche CA de silicium du substrat SOI) est bien plus grande que la vitesse de croissance du même matériau sur les autres surfaces en présence (notamment le masque dur MA ou bien les espaceurs secondaires extrême SE1E, SE2E - par exemple 10 fois plus importante). Ainsi, la source et le drain sont surélevés par rapport au substrat ST, et plus particulièrement, sur les figures, la couche de silicium CA, ce qui présentent des avantages au niveau des porteurs de charge.

L'étape 1E7 de création du module source-drain S/D comprend une sous-étape 1E72 de dopage de la couche de silicium ainsi déposée suivie d'une sous-étape 1E73 de recuit pour l'activation. Il est intéressant de noter ici que la présence du masque dur MA élimine le risque de dopage des zones entre les empilements de grille EGx, ce qui permet de diminuer la hauteur desdites empilements EGx. En outre, la source S et le drain D étant séparés de l'empilement de grille EGx le plus proche par un unique espaceur secondaire extrême SExE, la distance séparant la source ou le drain S/D de l'empilement de grille EG1, EG3 qui leur est le plus proche est contrôlée de manière précise, cette dernière étant fixée par la largeur des espaceurs secondaires extrêmes SExE. De plus, cette étape de création du module source-drain S/D peut être cointégrée à un procédé CMOS classique.

Dans un mode de réalisation, le procédé comprend également une étape 1E8 de retrait du masque dur MA, par exemple au moyen d'une gravure humide comme une gravure au H₃PO₄.

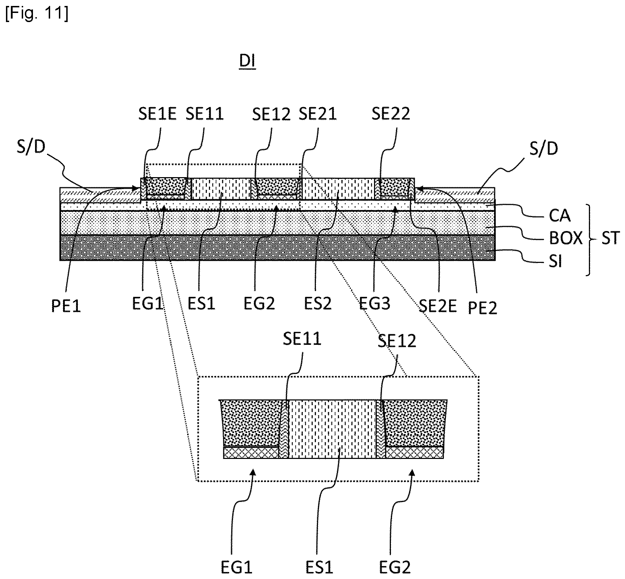

Le dispositif DI obtenu à l'issue de cette étape est illustré à la figure 11. Comme illustré dans l'encadré de la figure 11 pour le premier empilement de grille EG1 et le deuxième empilement de grille EG2, le dispositif DI comporte une pluralité d'empilements de grille EGx, chaque empilement de grille EGx étant séparés de l'empilement de grille EGx suivant/précédent par trois espaceurs : deux espaceurs secondaires SExx dont la largeur est identique quel que soit le couple d'empilements de grille EGx considéré et un espaceur principal ESx dont la largeur peut varier en fonction du couple d'empilements de grille EGx considéré. Ainsi, il est possible d'obtenir une alternance d'espaceurs fin (secondaire SExx)/épais (principal ESx)/ fin (secondaire SExx) entre chaque empilement de grille EGx lorsque la largeur de l'espaceur principal ESx est supérieure à celle des espaceurs secondaires SExx. En général, mais non limitativement, un espaceur forme une bague autour de l'empilement de grille EGx, avec un contour fermé. Les dessins en coupe, montrent deux parties d'espaceur de part et d'autre des flancs de l'empilement de grille EGx. Par extension, ces deux parties d'espaceur peuvent être désignées par « les espaceurs ». Par ailleurs, l'invention s'étend aux modes de réalisation dans lesquels au moins deux espaceurs discontinus flanquent l'empilement de grille EGx.

Aussi, un deuxième aspect de l'invention concerne un dispositif DI semiconducteur susceptible d'être obtenu par un procédé 100 tel que décrit précédemment. Un tel dispositif DI comprend un substrat ST, par exemple un substrat de type SOI tel que décrit précédemment. Le dispositif comprend également une pluralité d'empilements de grille EGx situés horizontalement à la suite les uns des autres horizontalement sur le substrat ST, chaque empilement de grille EGx comprenant une couche OG d'un matériau diélectrique en contact avec le substrat ST et une couche GR d'un matériau conducteur sur la couche OG d'un matériau diélectrique. Le dispositif DI comprend aussi une source et un drain S/D situés sur le substrat ST de part et d'autre de la pluralité d'empilements de grille EGx. Le dispositif DI comprend en outre une pluralité de premiers espaceurs SExx dans un premier matériau diélectrique, dit espaceurs secondaires SExx, ayant une première largeur identique pour tous les espaceurs secondaire SExx, dite largeur des espaceurs secondaires, la source et le drain S/D étant séparés de l'empilement de grille EGx le plus proche par un espaceur secondaire, dit espaceur secondaire extrême SExE. Le dispositif DI comprend aussi au moins un espaceur principal ESx dans un deuxième matériau diélectrique, deux espaceurs secondaires SExx et un espaceur principal ESx intercalé entre les deux espaceurs secondaires SExx étant situés entre chaque empilement de grille EGx, la largeur de l'espaceur principal ESx étant supérieure à la largeur des espaceurs secondaire SExx. Dans un mode de réalisation, le premier matériau diélectrique des espaceurs secondaires SExx est différent du deuxième matériau diélectrique des espaceurs principaux ESx. De préférence, le premier matériau diélectrique et le deuxième matériau diélectrique sont des matériaux ayant une faible constante diélectrique. De préférence, l'épaisseur du substrat ST (en particulier, sur les figures, de la couche de silicium CA) entre les deux espaceurs secondaires extrêmes SExE est constante, l'intégrité de la couche dans laquelle est réalisée la partie active du dispositif étant ainsi préservée. Un tel dispositif DI est particulièrement avantageux pour l'électronique quantique, en particulier pour l'obtention de qbits de spin dans un matériau semiconducteur tel que le silicium.

## Revendications

1. Procédé (100) de fabrication d'un dispositif semiconducteur (DI) à partir d'un substrat (ST), ledit procédé (100) comprenant :
- une étape (1E1) de dépôt, sur le substrat (ST), d'une première couche (E1) d'un matériau diélectrique selon une première épaisseur prédéterminée ;
- une étape (1E2) de gravure d'une partie de la première couche (E1) d'un matériau diélectrique sur la totalité de la première épaisseur définissant, dans la première couche (E1) d'un matériau diélectrique, une pluralité de cavités (Cx) séparées par des espaceurs (ESx), dit espaceurs principaux, chaque cavité (Cx) ayant une première paroi latérale et une deuxième paroi latérale, les deux parois latérales de cavités (Cx) les plus éloignées l'une de l'autre étant désignées par parois extrêmes (PEx) ;
- une étape (1E3) de dépôt d'une deuxième couche (SExx) d'un matériau diélectrique sur les parois latérales des cavités (Cx) définies lors de l'étape (1E2) précédente, de sorte à définir une pluralité d'espaceurs secondaires (SExx) sur les espaceurs principaux (ESx) et les parois extrêmes (PEx) ;
- une étape (1E4) de création, dans chaque cavité (Cx), d'un empilement de grille (EGx) comprenant une troisième couche (OG) d'un matériau diélectrique en contact avec le substrat (ST) et d'une quatrième couche (GR) d'un matériau conducteur sur la troisième couche (OG) du matériau diélectrique, l'empilement de grille (EGx) ainsi créé ayant une hauteur supérieure ou égale à la première épaisseur ;
- une étape (1E5) de création d'un masque dur (MA), ledit masque dur recouvrant entièrement les empilements de grille (EG) ainsi que les espaceurs principaux (ESx) et secondaire (SExx) ;
- une étape (1E6) de gravure de la partie de première couche (E1) d'un matériau diélectrique non protégée par le masque dur (MA), la gravure étant effectuée sur la totalité de la première épaisseur ;
- une étape (1E7) de création d'un module source-drain (S/D) dans les zones laissées libres par la partie de la première couche (E1) gravée lors de l'étape (1E6) de gravure précédente.

2. Procédé selon la revendication précédente comprenant en outre une étape (1E8) de retrait du masque dur (MA).

3. Procédé selon l'une des revendications précédentes dans lequel le masque dur forme avec chaque parois extrême (PEx) un rebord (RBx).

4. Procédé (100) selon l'une des revendications précédentes dans lequel l'étape (1E3) de dépôt d'une deuxième couche d'un matériau diélectrique sur les parois latérales des cavités (Cx) comprend :
- une sous-étape (1E31) de dépôt d'une couche d'un matériau diélectrique ; et
- une sous-étape (1E32) de gravure de la deuxième couche d'un matériau diélectrique de sorte à ne laisser la deuxième couche d'un matériau diélectrique que sur les parois latérales des cavités (Cx).

5. Procédé (100) selon l'une des revendications précédentes dans lequel l'étape (1E4) de création, dans chaque cavité (Cx), d'un empilement de grille (EGx) comprend :
- une sous-étape (1E41) de dépôt ou de croissance de la troisième couche (OG) d'un matériau diélectrique sur le substrat (ST) ;
- une sous-étape (1E42) de dépôt de la quatrième couche (GR) d'un matériau conducteur sur la troisième couche (OG) d'un matériau diélectrique ; et
- une sous-étape (1E43) de polissage chimio-mécanique de sorte que l'empilement de grille (EGx) ait une hauteur égale à la première épaisseur.

6. Procédé (100) selon l'une des revendications précédentes dans lequel l'étape (1E5) de création d'un masque dur (MA) comprend :
- une sous-étape (1E51) de dépôt d'une couche destinée à former le masque dur (MA) ;
- une sous-étape (1E52) de lithographie de sorte à définir la zone formant le masque dur (MA) ;
- une sous-étape (1E53) de gravure de la couche destinée à former le masque dur (MA) en fonction de la zone définie lors de la sous-étape de lithographie ; et
- une sous-étape (1E54) de délaquage de sorte à définir le masque dur (MA).

7. Procédé (100) selon l'une des revendications précédentes dans lequel l'étape (1E7) de création d'un module source-drain (S/D) comprend :
- une sous-étape (1E71) de croissance sélective d'une couche de silicium dans la zone laissée libre par la partie de la première couche (E1) gravée lors de l'étape (1E6) précédente ;
- une sous-étape (1E72) de dopage de la couche de silicium ainsi déposée ;
- une sous-étape (1E73) d'activation des dopants.

8. Procédé (100) selon l'une des revendications précédentes dans lequel le substrat (ST) est un substrat (ST) de type SOI.

9. Dispositif (DI) semiconducteur comprenant :
- un substrat (ST) ;
- une pluralité d'empilements de grille (EGx) situés horizontalement à la suite les uns des autres sur le substrat (ST), chaque empilement de grille (EGx) comprenant une couche (OG) d'un matériau diélectrique en contact avec le substrat (ST) et une couche (GR) d'un matériau conducteur sur la couche (OG) d'un matériau diélectrique ;
- une source et un drain (S/D) situés sur le substrat de part et d'autre de la pluralité d'empilements de grille (EGx) ;
- une pluralité de premiers espaceurs (SExx) dans un premier matériau diélectrique, dit espaceurs secondaires (SExx), ayant une première largeur identique pour tous les espaceurs secondaires (SExx), dite largeur des espaceurs secondaires, la source et le drain étant séparés de l'empilement de grille (EGx) le plus proche par un unique espaceur secondaire (SExE) ;
- au moins un espaceur principal (ESx) dans un deuxième matériau diélectrique, deux espaceurs secondaires (SExx) et un espaceur principal (ESx) intercalé entre les deux espaceurs secondaires (SExx) étant situés entre chaque empilement de grille (EGx) ;
la largeur du ou des espaceurs principaux (ESx) étant supérieure à la largeur des espaceurs secondaires (SExx).

10. Dispositif (DI) selon la revendication précédente dans lequel le substrat (ST) est un substrat (ST) de type SOI.

11. Dispositif (DI) selon l'une des deux revendications précédentes dans lequel le matériau composant les espaceurs secondaires (SExx) est différent du matériau composant le ou les espaceurs principaux (ESxx).

12. Dispositif (DI) selon l'une des trois revendications précédentes dans lequel la largeur des espaceurs secondaires (SExx) est comprise entre 3 nm et 15 nm.

13. Dispositif (DI) selon l'une des quatre revendications précédentes comprenant au moins deux empilements de grille (EGx).

14. Dispositif selon l'une des cinq revendications précédentes dans lequel la source (S) et le drain (D) sont surélevés par rapport au substrat (ST).
